# EUROPEAN PATENT APPLICATION

(11) **EP 2 544 244 A1**
(43) Date of publication of application: **09.01.2013**
(21) Application number: 11750743.4
(22) Date of filing: 03.03.2011
(51) Int. Cl.: H01L 31/042

(54) **SOLAR CELL MODULE**

(30) Priority: 05.03.2010 JP 2010049547
(71) Applicant: Sanyo Electric Co., Ltd., Osaka 570-8677 (JP)
(72) Inventor: HISHIDA Yuji, Moriguchi-shi Osaka 570-8677 (JP)
(74) Representative: Calderbank, Thomas Roger
(86) International application number: PCT/JP2011/054887
(87) International publication number: WO 2011/108634

(57) **Abstract**

[Problem]

To provide a solar cell module including solar cells wired by a wiring member which can be easily manufactured.

[Solving Means]

Solar cell module 1 includes solar cells 10 and wiring member 11 connecting solar cells 10. At least one side portion 11a1 of wiring member 11 is bonded to a portion where both first and second electrodes 23, 24 of first principal surface 20b are provided, by adhesive resin layer 12. A first portion of conductive adhesive layer 12, which is located between portion 11a1 of wiring member 11 and electrode 23 is thinner than a second portion of conductive adhesive layer 12, which is located between portion 11a1 of wiring member 11 and second electrode 24 such that portion 11a1 of wiring member 11 is electrically connected with first electrode 23 while portion 11a1 of wiring member 11 is electrically insulated from second electrode 24.

## Description

### TECHNICAL FIELD

The invention relates to a solar cell module. In particular, the invention relates to a solar cell module in which solar cells are wired by a wiring member.

### BACKGROUND ART

A solar cell module has been conventionally known in which solar cells, each having both a positive electrode and a negative electrode provided on one principal surface of the solar cell, are electrically wired by a wiring member. Such solar cell module includes, for example, a through-hole type solar cell and a back junction type solar cell described in PATENT DOCUMENT 1 listed below.

In the above-described solar cell module, there may be a case where the wiring member has to be bonded to a portion of the solar cell module where both the positive electrode and the negative electrode are provided. In such a case, it is necessary to electrically connect one of the positive electrode and the negative electrode with the wiring member and to insulate the other of the positive electrode and the negative electrode from the wiring member. For this reason, for example, PATENT DOCUMENTS 2, 3 listed below propose that a conductive layer made of a conductive resin or a low melting-point metal is selectively formed on a surface of a solar cell to electrically connect one of a positive electrode and a negative electrode with a mounting board, while other portions of the surface of the solar cell are bonded to the mounting board by an insulation adhesive.

### PRIOR ART DOCUMENTS

### PATENT DOCUMENTS

PATENT DOCUMENT 1: Japanese Patent Application Publication No. 2005-191479
PATENT DOCUMENT 2: Japanese Patent Application Publication No. 8-298334
PATENT DOCUMENT 3: Japanese Patent Application Publication No. 2006-344616

### SUMMARY OF THE INVENTION

### PROBLEMS TO BE SOLVED BY THE INVENTION

However, the methods described in PATENT DOCUMENTS 2, 3 require to selectively form a conductive layer. Accordingly, the process of manufacturing a solar cell module become complicated, which results in a problem that a manufacturing cost for the solar cell module is increased.

The invention has been made in view of the foregoing problem, and an object of the invention is to provide a solar cell module including solar cells wired by a wiring member which can be easily manufactured.

### MEANS FOR SOLVING THE PROBLEM

A solar cell module according to the invention includes solar cells and a wiring member. Each of the solar cells has first and second principal surfaces. First and second electrodes which respectively have polarities different from each other are formed on the first principal surface. The wiring member connects the solar cells. At least one side portion of the wiring member is bonded to a portion of the first principal surface of the solar cell where both the first and second electrodes are provided, by an adhesive resin layer. A first portion of the adhesive resin layer, which is located between the one side portion of the wiring member and the first electrode, is thinner than a second portion of the adhesive resin layer, which is located between the one side portion of the wiring member and the second electrode such that the one side portion of the wiring member is electrically connected with the first electrode, while the one side portion of the wiring member is electrically insulated from the second electrode.

In the invention, the "wiring member" means a member electrically connecting the solar cells. A shape and size of the wiring member are not particularly limited. For example, the wiring member may be a wire-shaped member or plate-shaped member. Also, the wiring member may be a printed circuit board having a printed circuit formed therein or on a surface thereof.

In the solar cell module according to the invention, the adhesive resin layer may contain a resin and conductive particles dispersed in the resin. In this case, it is preferable that a minimum thickness of the first portion of the adhesive resin layer be equal to or smaller than a maximum particle diameter of the conductive particles and a minimum thickness of the second portion of the adhesive resin layer be larger than the maximum particle diameter of the conductive particles.

In the solar cell module according to the invention, the at least one side portion of the wiring member may be in contact with the first electrode.

In the solar cell module according to the invention, it is preferable that the adhesive resin layer be formed between at least the one side portion of the wiring member and the first electrode.

In the solar cell module according to the invention, the first electrode may have a protruded portion and a recessed portion on the surface, and the protruded portion on the surface of the first electrode may be in contact with at least the one side portion of the wiring member and the adhesive resin layer may be provided between the recessed portion on the surface of the first electrode and at least the one side portion of the wiring member.

In the solar cell module according to the invention, the adhesive resin layer is preferably provided entirely across a region where the one side portion of the wiring member faces the solar cell.

In the solar cell module according to the invention, each solar cell may include a photoelectric conversion body, a light-receiving-surface electrode, a connection electrode, a first electrode, and a rear-surface electrode. Here, the photoelectric conversion body has a light-receiving surface as the second principal surface and a rear surface as the first principal surface. The photoelectric conversion body has a through-hole formed therein, the through-hole connecting the light-receiving surface and the rear surface. The photoelectric conversion body is configured to generate carriers by receiving light on the light-receiving surface. The light-receiving-surface electrode is provided on the light-receiving surface of the photoelectric conversion body. The connection electrode is formed in the through-hole. The connection electrode is electrically connected with the light-receiving-surface electrode. The first electrode is provided on the rear surface of the photoelectric conversion body. The first electrode is electrically connected with the light-receiving-surface electrode via the connection electrode. The rear-surface electrode is provided on the rear surface of the photoelectric conversion body. The rear-surface electrode serves as the second electrode.

In the solar cell module according to the invention, each solar cell may include a semiconductor substrate and a semiconductor layer. Here, the semiconductor substrate has a light-receiving surface and a rear surface. The light-receiving surface comprises the second principal surface. The rear surface comprises the first principal surface. The semiconductor substrate is made of one of a p-type semiconductor and an n-type semiconductor. The semiconductor layer is formed on one portion of the rear surface of the semiconductor substrate. The semiconductor layer is made of the other of the p-type semiconductor and the n-type semiconductor. One of the first and second electrodes is formed on the rear surface of the semiconductor substrate. The other of the first and second electrodes is formed on the semiconductor layer.

In this case, the first electrode preferably includes line-shaped first finger electrodes which are provided in parallel with each other. The second electrode preferably includes second finger electrodes, which are provided in parallel with the first finger electrodes and are alternately provided with the first finger electrodes in a direction perpendicular to a direction in which the first finger electrodes extend.

In the solar cell module according to the invention, the wiring member may be formed in a plate shape and a portion of the at least the one side portion of the wiring member that is provided above the first electrode may be curved protruding toward the first electrode, so that the first portion of the adhesive resin layer may be formed to be thin.

In the solar cell module according to the invention, a portion of at least the one side portion of the wiring member may be formed to be thicker than the other portions, the portion being electrically connected with the first electrode.

In the solar cell module according to the invention, an end portion of the first electrode on the wiring member side may be located closer to the wiring member side than an end portion of the second electrode on the wiring member side.

In the solar cell module according to the invention, the end portion of the at least one side of the wiring member is preferably electrically connected with the first electrode.

### EFFECTS OF THE INVENTION

According to the invention, the solar cell module including the solar cells wired by the wiring member can be easily manufactured.

### BRIEF DESCRIPTION OF DRAWINGS

[Fig. 1] Fig. 1 is a schematic cross-sectional view of a solar cell module according to a first embodiment.
[Fig. 2] Fig. 2 is a schematic plan view of a light-receiving surface of a solar cell according to the first embodiment.
[Fig. 3] Fig. 3 is a schematic plan view of a rear surface of the solar cell according to the first embodiment.
[Fig. 4] Fig. 4 is a schematic rear view for illustrating a connection structure between solar cells in the first embodiment.
[Fig. 5] Fig. 5 is a schematic cross-sectional view taken along line V-V in Fig. 4.
[Fig. 6] Fig. 6 is a schematic cross-sectional view of enlarged portion VI in Fig. 5.
[Fig. 7] Fig. 7 is a schematic cross-sectional view of enlarged portion VII in Fig. 6.
[Fig. 8] Fig. 8 is a schematic cross-sectional view of enlarged portion VIII in Fig. 5.
[Fig. 9] Fig. 9 is a schematic cross-sectional view of enlarged portion IX in Fig. 5.
[Fig. 10] Fig. 10 is a schematic cross-sectional view of a solar cell module according to a second embodiment.
[Fig. 11] Fig. 11 is a schematic plan view of a rear surface of a solar cell according to the second embodiment.
[Fig. 12] Fig. 12 is a schematic rear view for illustrating a connection structure between solar cells in the second embodiment.
[Fig. 13] Fig. 13 is a schematic cross-sectional view taken along line XIII-XIII in Fig. 12.
[Fig. 14] Fig. 14 is a schematic cross-sectional view taken along line XIV-XIV in Fig. 12.
[Fig. 15] Fig. 15 is a schematic cross-sectional view for illustrating a connection structure between solar cells and a wiring member in a solar cell module according to a first modification.
[Fig. 16] Fig. 16 is a schematic cross-sectional view for illustrating a connection structure between solar cells and a wiring member in a solar cell module according to a second modification.
[Fig. 17] Fig. 17 is a schematic cross-sectional view for illustrating a connection structure between solar cells and a wiring member in a solar cell module according to a third modification.
[Fig. 18] Fig. 18 is a schematic cross-sectional view for illustrating a connection structure between solar cells and a wiring member in a solar cell module according to a fourth modification.
[Fig. 19] Fig. 19 is a schematic cross-sectional view for illustrating a connection structure between solar cells and a wiring member in a solar cell module according to a fifth modification.
[Fig. 20] Fig. 20 is a schematic cross-sectional view for illustrating a connection structure between solar cells and a wiring member in a solar cell module according to a sixth modification.
[Fig. 21] Fig. 21 is a schematic cross-sectional view for illustrating a connection structure between solar cells and a wiring member in a solar cell module according to a seventh modification.
[Fig. 22] Fig. 22 is a schematic cross-sectional view for illustrating a connection structure between solar cells and a wiring member in a solar cell module according to an eighth modification.

### MODES FOR CARRYING OUT THE INVENTION

### «First Embodiment»

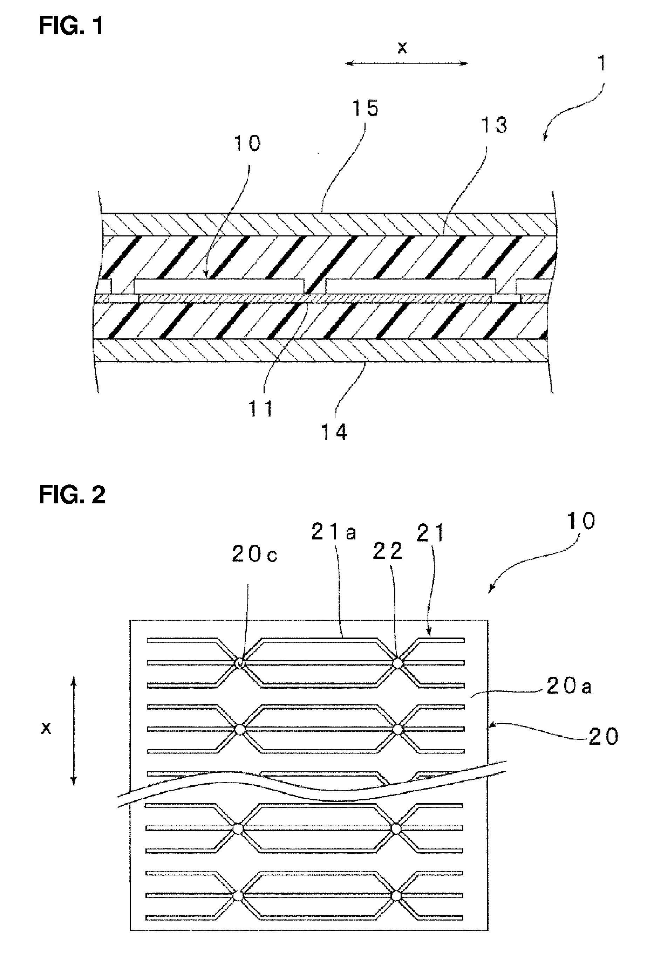

Hereinafter, preferable embodiments in which the invention is implemented are described using solar cell module 1 shown in Fig. 1 as an example. However, solar cell module 1 is only exemplary. The invention is not limited to solar cell module 1 at all.

Also, in each drawing referred in the embodiments or the like, it is assumed that members having substantially same functions are referred by same reference numerals. Also, the drawings referred in the embodiments or the like are schematically shown, and proportions of sizes of objects depicted in the drawings may be different from actual ones. In addition, there may be a case where proportions of sizes of objects differ from one another between the drawings. The specific proportions of sizes of objects should be judged by considering the following description.

### (Schematic Configuration of Solar Cell Module 1)

Fig. 1 is a schematic cross-sectional view of a solar cell module according to a first embodiment. At first, a schematic configuration of solar cell module 1 is described by referring to Fig. 1.

As shown in Fig. 1, solar cell module 1 includes solar cells 10 which are arranged in an arrangement direction X. Solar cells 10 are electrically connected by wiring members 11. Specifically, adjacent solar cells 10 are electrically connected with each other by wiring members 11. Accordingly, solar cells 10 are electrically connected in series or in parallel. Note that wiring member 11 is not particularly limited as long as it is conductive. Wiring member 11 may be formed of, for example, a metal such as iron, aluminum, or copper or an alloy containing one kind of these metals.

First and second protective members 14, 15 are respectively provided on the light-receiving surface side and the rear surface side of solar cells 10. Sealant 13 is filled between first protective member 14 and second protective member 15. This sealant 13 seals solar cells 10.

Note that materials of sealant 13 and first and second protective members 14, 15 are not particularly limited. Sealant 13 is formed of, for example, a translucent resin such as ethylene-vinyl acetate copolymer (EVA) or polyvinyl butyral.

First and second protective members 14, 15 can be formed of a glass or a resin, for example. Also, first protective member 14 may be formed of, for example, a resin film incorporating a metal foil such as an aluminum foil.

In the embodiment, first protective member 14 is disposed on the rear surface side of solar cells 10 and is formed of a resin film incorporating a metal foil such as an aluminum foil. Second protective member 15 is deposed on the light-receiving surface side of solar cells 10 and is formed of a glass or resin.

### (Configuration of Solar Cell)

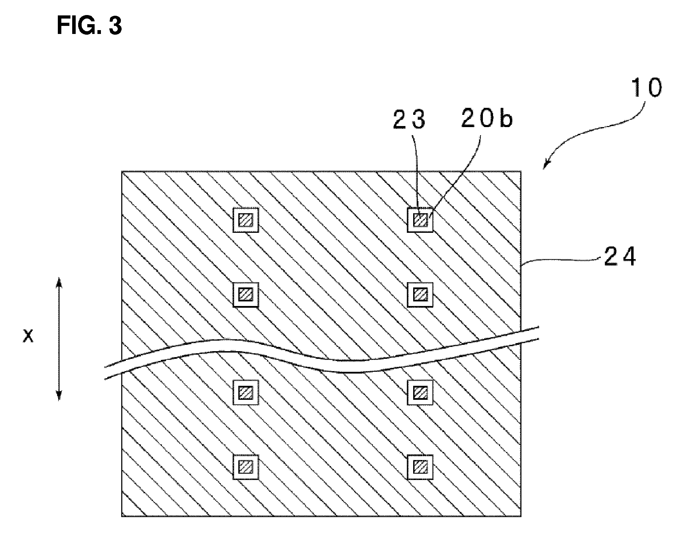

Fig. 2 is a schematic plan view of the light-receiving surface of the solar cell according to the first embodiment. Fig. 3 is a schematic plan view of the rear surface of the solar cell according to the first embodiment. In Fig. 3, hutching are added in a region where collecting electrode 24 is provided and in regions where electrodes 23 are provided, to facilitate explanation.

Next, the configuration of solar cell 10 is described by mainly referring to Figs. 2 and 3.

Note that solar cell 10 described here is just an example. The type and the configuration of the solar cell are not limited at all in the invention. For example, in the invention, the solar cell may be a HIT (registered trademark) solar cell having the HIT structure or other configurations. Also, for example, in the invention, the solar cell may be a back junction type solar cell. Furthermore, for example, in the invention, the solar cell may have a BSF configuration.

Also, in the embodiment, one principal surface of solar cell 10 is a light-receiving surface and the other principal surface is a rear surface, but in the invention, both principal surfaces of the solar cell may be light-receiving surfaces. In this case, each of the above-described first and second protective members preferably has translucency.

As shown in Fig. 2, solar cell 10 has photoelectric conversion body 20. Photoelectric conversion body 20 generates photo-generated carriers (electrons and holes) by receiving light on light-receiving surface 20a.

Photoelectric conversion body 20 is formed of a semiconductor material having a semiconductor junction such as a PN junction or a PIN junction. An example of the semiconductor material includes, for example, crystalline semiconductor such as monocrystalline silicon or polycrystalline silicon, amorphous semiconductor, or compound semiconductor such as GaAs.

Photoelectric conversion body 20 has light-receiving surface 20a shown in Fig. 2 and rear surface 20b shown in Fig. 3. As shown in Fig. 3, collecting electrode 24 serving as a rear-surface electrode is formed on rear surface 20b in a planar fashion. On the other hand, as shown in Fig. 2, collecting electrode 21 serving as a light-receiving-surface electrode is formed on light-receiving surface 20a. In order to increase the amount of light received by light-receiving surface 20a, an area of collecting electrode 21 is smaller than an area of collecting electrode 24.

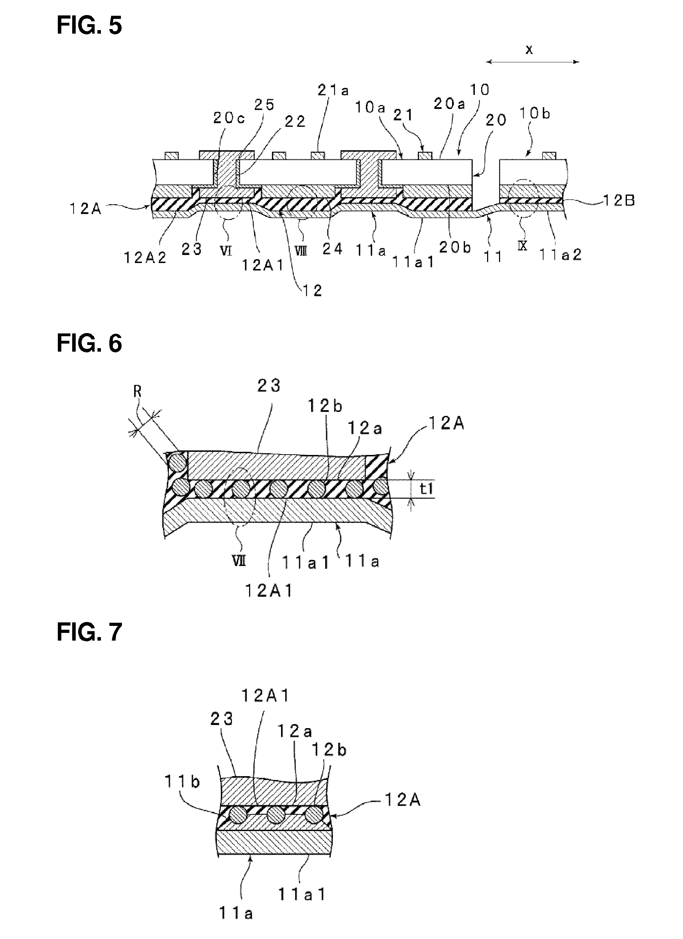

Collecting electrode 21 comprises finger electrodes 21a. Every three of finger electrodes 21a are tied. As shown in Fig. 2 and Fig. 5, through-holes 20c connecting light-receiving surface 20a and rear surface 20b are formed through photoelectric conversion body 20. The tied three finger electrodes 21a are connected with electrode 23 (see Fig. 3 and Fig. 5) formed on rear surface 20b of photoelectric conversion body 20 through connection electrode 22 formed inside through-hole 20c. In the embodiment, as shown in Fig. 3, two lines of electrodes 23 are linearly formed along the arrangement direction X on rear surface 20b. Electrodes 23 and collecting electrode 24 are formed such that electrodes 23 are spaced apart from collecting electrode 24. Also, as shown in Fig. 5, insulation films 25 are formed between electrodes 23 and photoelectric conversion body 20 and between connection electrodes 22 and photoelectric conversion body 20.

Electrodes 23, connection electrodes 22 and collecting electrodes 21 have different polarities from collecting electrode 24. Specifically, for example, electrodes 23, connection electrodes 22, and collecting electrodes 21 are one of a positive electrode (p-side electrode) and a negative electrode (n-side electrode) while collecting electrode 24 is the other of the positive electrode (p-side electrode) and the negative electrode (n-side electrode). In other words, in the embodiment, electrodes 23 and collecting electrode 24 whose polarities are different from each other are formed on rear surface 20b.

As shown in the embodiment, three finger electrodes 21 a are connected with common electrode(s) 23, so that the number of electrodes 23 can be reduced. Accordingly, a ratio of the area of electrodes 23 to the area of rear surface 20b of photoelectric conversion body 20 can be reduced. This increases a degree of freedom in arrangement of collecting electrode 24 on rear surface 20b of photoelectric conversion body 20 and increases the area of a region where collecting electrode 24 is provided. Thus, further increased photoelectric conversion efficiency can be achieved.

Note that although the embodiment describes the example in which every three of finger electrodes 21 a are connected with the common electrode(s), the invention is not limited to this configuration. In the invention, the finger electrodes may be respectively connected with different electrodes, or two or four or more of the finger electrodes may be connected with the common electrode(s).

Collecting electrodes 21, connection electrodes 22, electrodes 23, and collecting electrode 24 may be formed of any conductive material. Specifically, for example, collecting electrodes 21, connection electrodes 22, electrodes 23, and collecting electrode 24 may be formed by using a thermosetting conductive paste including an epoxy resin as a binder and conductive particles as filler. Also, collecting electrodes 21, connection electrodes 22, electrodes 23, and collecting electrode 24 may be formed by using a burning paste formed of conductive powder including silver or aluminum, a glass flit, and an organic vehicle, or may be formed of a metal film such as silver or aluminum or an alloy film containing one or more of these metals.

### (Connection structure between Solar Cell 10)

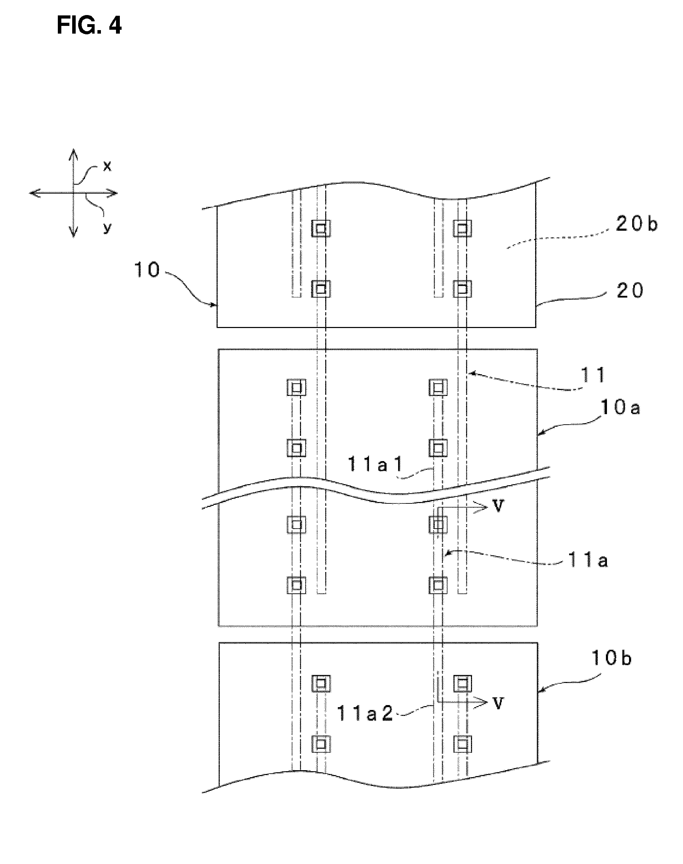

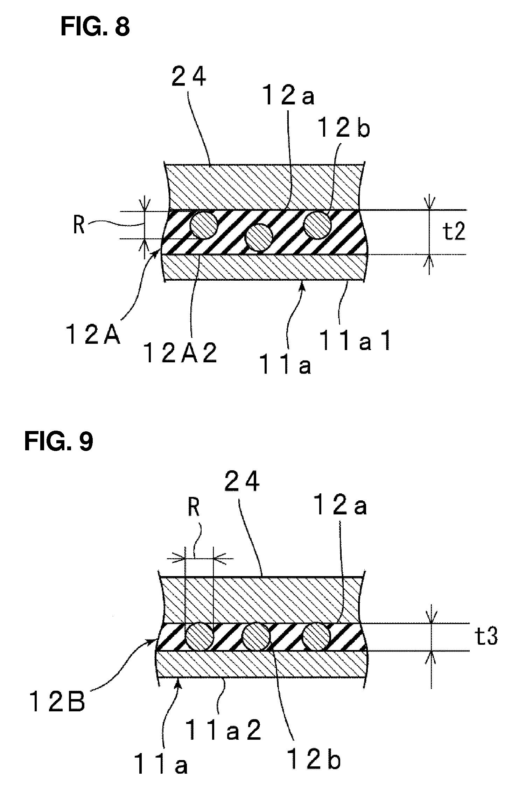

Fig. 4 is a schematic rear view for illustrating a connection structure between the solar cells in the first embodiment. Fig. 5 is a schematic cross-sectional view taken along line V-V in Fig. 4. Fig. 6 is a schematic cross-sectional view of enlarged portion VI in Fig. 5. Fig. 7 is a schematic cross-sectional view of enlarged portion VII in Fig. 6. Fig. 8 is a schematic cross-sectional view of enlarged portion VIII in Fig. 5. Fig. 9 is a schematic cross-sectional view of enlarged portion IX in Fig. 5.

Hereafter, the connection structure between solar cells 10 in the embodiment is described in detail by mainly referring to Figs. 4 to 9.

In the embodiment, solar cells 10 are arranged such that, in vertical direction Y perpendicular to the arrangement direction X, positions where electrodes 23 are provided in one of adjacent solar cells 10 are different from positions where electrodes 23 are provided in the other of adjacent solar cells 10. Such adjacent solar cells 10 are connected with each other with two plate-shaped wiring members 11.

Hereinafter, the connection structure between solar cells 10a and 10b shown in Fig. 4 and Fig. 5 is described as an example of the connection structure between solar cells 10.

As shown in Fig. 4, solar cell 10a and solar cell 10b are connected with each other with two wiring members 11 a. Each wiring member 11 a is provided along the arrangement direction X. One side portion 11a1 of wiring member 11a is located on a portion on rear surface 20b of solar cell 10a where both electrodes 23 and collecting electrode 24 are provided. On the other hand, the other side portion 11a2 of wiring member 11a is located on a portion on rear surface 20b of solar cell 10b where only electrode 24 is provided.

As shown in Fig. 5, wiring members 11a are bonded to solar cells 10a, 10b with anisotropic conductive adhesive layers 12. Specifically, wiring members 11a are bonded to solar cell 10a with anisotropic conductive adhesive layers 12A. Wiring members 11a are bonded to solar cell 10b with anisotropic conductive adhesive layers 12B. Each anisotropic conductive adhesive layers 12A is provided across the region where each wiring member 11a face the solar cell 10a whereas each anisotropic conductive adhesive layer 12B is provided across the region where each wiring member 11a face solar cell 10b.

As shown in Fig. 6 to Fig. 8, anisotropic conductive adhesive layer 12 is formed of resin 12a containing conductive particles 12b dispersed in resin 12a.

Note that an example of the material of resin 12a in anisotropic conductive adhesive layer 12 includes, for example, an epoxy resin, acryl resin, polyimide resin, phenol resin, urethane resin, silicon resin or mixture or copolymer of these resins.

An example of conductive particles 12b of anisotropic conductive adhesive layer 12 includes particles formed of a metal such as nickel, copper, silver, aluminum, tin, or gold or an alloy containing one or more of these metals. Also, conductive particles 12b may be insulation particles which are subjected to conductive coating such as metal coating or alloy coating. An example of the insulation particles include, for example, inorganic oxide particles or resin particles. An example of the inorganic oxide particles includes, for example, particles formed of inorganic oxides such as alumina, silica, oxidized titanium, or glass. An example of the resin particles includes, for example, particles formed of an epoxy resin, acryl resin, polyimide resin, phenol resin, urethane resin, silicon resin, or mixture or copolymer of these resins.

The shape of conductive particles 12 is not particularly limited. Conductive particles 12b may be, for example, sphere or spheroid.

As shown in Fig. 9, minimum thickness t3 of anisotropic conductive adhesive layer 12B located between collecting electrode 24 of solar cell 10b and the other side portion 11a2 of wiring member 11 is equal to or smaller than maximum particle diameter R of conductive particles 12b. With this configuration, the other side portion 11a2 of each wiring member 11a is electrically connected to collecting electrode 24 of solar cell 10b with conductive particles 12b.

As shown in Figs. 5 to 7, first portion 12A1 of anisotropic conductive adhesive layer 12A (see, Fig. 5 and Fig. 6), which is located between one side portion 11a of wiring member 11a and each electrode 23, is formed to be thinner than second portion 12A2, which is located between one side portion 11a1 of wiring member 11a and collecting electrode 24, such that one side portion 11a1 of each wiring member 11a is electrically connected to electrodes 23 of solar cell 10a while one side portion 11a1 of each wiring member 11a is electrically insulated from and collecting electrode 24 of solar cell 10a.

Specifically, as shown in Fig. 6, minimum thickness t1 of first portion 12A1 of anisotropic conductive adhesive layer 12A is equal to or smaller than maximum particle diameter R of conductive particles 12b. More specifically, in the embodiment, as shown in Fig. 7, minimum thickness t1 of first portion 12A1 is smaller to the extent such that a part of conductive particle 12b is deep into solder layer 11b provided on the surface of wiring member 11a on the electrode 23 side. With this configuration, wiring member 11a is electrically connected to electrodes 23 through conductive particles 12b.

On the other hand, as shown in Fig. 8, minimum thickness t2 of second portion 12A2 of anisotropic conductive adhesive layer 12A is larger than the maximum particle diameter R of conductive particles 12b. With this configuration, wiring member 11a and collecting electrode 24 are electrically insulated by resin 12a.

With the configuration as such, in the embodiment, one side portion 11a1 of wiring member 11a is electrically connected with electrodes 23 of solar cell 10a and is electrically insulated from collecting electrode 24. Then, the other side portion 11a2 of wiring member 11a is electrically connected with collecting electrode 24 of solar cell 10a. Accordingly, electrodes 23 of solar cell 10a and collecting electrode 24 of solar cell 10b are electrically connected through wiring member 11a and anisotropic conductive adhesive layers 12A and 12B.

Also, as shown in Figs. 5 to 9, electrodes 23 or collecting electrode 24 is not in direct contact with wiring member 11a, and resin 12a exists between electrode 23 or collecting electrode 24 and wiring member 11a.

As shown in Fig. 4, the end of one side portion 11a1 of wiring member 11a is electrically connected with electrode 23.

Hereinafter, an example of a method of connecting solar cell 10a with wiring member 11a is described. Firstly, an anisotropic conductive adhesive is applied to a portion on rear surface 20b of solar cells 10a, 10b where wiring member 11a is to be bonded. After that, the anisotropic conductive adhesive is hardened, in a state where wiring member 11 a is pushed down to the solar cell 10a by a jig having a protruded portion such that the protruded portion is located on electrode 23, so that wiring member 11a can be electrically connected and bonded.

Note that an example of the method of applying an anisotropic conductive adhesive includes, for example, a printing method such as a screen printing method, offset printing method, gravure printing method, or inkjet printing method, or an application method using dispenser. Also, anisotropic conductive adhesive layer 12 can be formed by a method of affixing an anisotropic conductive adhesive in a film form, for example.

As described above, in the embodiment, one side portion 11a1 of wiring member 11a is bonded, with anisotropic conductive adhesive layer 12A as an adhesive resin layer, to the portion on rear surface 20b where both electrodes 23 and collecting electrode 24 are provided. Then, first portion 12A1 of anisotropic conductive adhesive 12A, which is located between one side portion 11a1 of wiring member 11a and each electrode 23, is formed to be thin, such that one side portion 11a1 of wiring member 11a is electrically connected with each electrode 23. On the other hand, second portion 12A2 of anisotropic conductive adhesive layer 12A, which is located between one side portion 11a1 of wiring member 11a and collecting electrode 24 is formed to be thick, such that one side portion 11a1 of wiring member 11a is electrically insulated from collecting electrode 24. For this reason, in the embodiment, one side portion 11a1 of wiring member 11a is bonded to the portion on rear surface 20b where both electrodes 23 and collecting electrode 24 are provided, and there is no need to selectively form different kinds of layers such as a conductive layer and an insulation layer to be electrically connected to electrodes 23. Also, for example, there is no need to use a wiring member having an insulation layer(s) formed in a part(s) of a surface thereof.

In the embodiment, as described above, an anisotropic conductive adhesive is applied entirely over each of the portions on rear surface 20b of solar cell 10a where both electrodes 23 and collecting electrode 24 are provided, and, thereafter, wiring member 11a is disposed on the anisotropic conductive adhesive on each of the portions, and is compressed and bonded onto rear surface 20b by using the jig with the protruded portions. Thus, each wiring member 11a is easily bonded and connected. Accordingly, solar cell module 1 including solar cells 10 connected to one another with wiring members 11 can be easily manufactured.

Also, in the embodiment, anisotropic conductive adhesive layer 12 as an adhesive resin layer is entirely formed over the connection portion where each wiring member 11 faces rear surface 20b of solar cell 10. For this reason, bonding strength between wiring members 11 and solar cell 10 is high. Accordingly, the connection reliability between wiring members 11 and solar cell 10 can be enhanced.

Furthermore, in the embodiment, resin 12a of anisotropic conductive adhesive layer 12A exists between a part(s) of wiring member 11a and a part(s) of electrodes 23a of solar cell 10a. For this reason, the bonding strength between wiring member 11a and electrodes 23a of solar cell 10a can be enhanced. Accordingly, the reliability of the electrical connection between wiring member 11a and electrodes 23a of solar cell 10a can be further enhanced.

Also, in the embodiment, as shown in Fig. 4, the end portion of one side portion 11a1 of wiring member 11a is electrically connected with electrode 23. In other words, the end portion of one side portion 11a1 of wiring member 11a is bonded to electrode 23 by both adhesive force of resin 12a and physical adhesive force due to conductive particles 12b getting into wiring member 11a or electrodes 23. Accordingly, each end portion of wiring member 11a is bonded to solar cell 10 with higher adhesive force, which effectively suppresses delaminating of wiring member 11a from the end portion thereof. Also, for example, even in a case where another portion of wiring member 11a is bonded to rear surface 20b after wiring member 11a is electrically connected with electrode 23, the delaminating of wiring member 11a from the end portion of wiring member 11a can be effectively suppressed in the step of bonding wiring member 11a.

Also, in the embodiment, the portion, which is electrically connected with each electrode 23, of one side portion 11a1 of wiring member 11a is convex toward the electrode 23, so that thickness t1 of first portion 12A1 is smaller than thickness t2 of second portion 12A2. For this reason, in the embodiment, a plate-shaped wiring member can be used. That is, there is no need to prepare, for example, a special wiring member partially having protruded portions.

Hereinafter, another embodiment and modifications of preferable embodiments implementing the invention are described. Note that, in the following description, members having substantially the same functions as those of the first embodiment are referred by the same reference numerals, and the description thereof is omitted.

### «Second Embodiment»

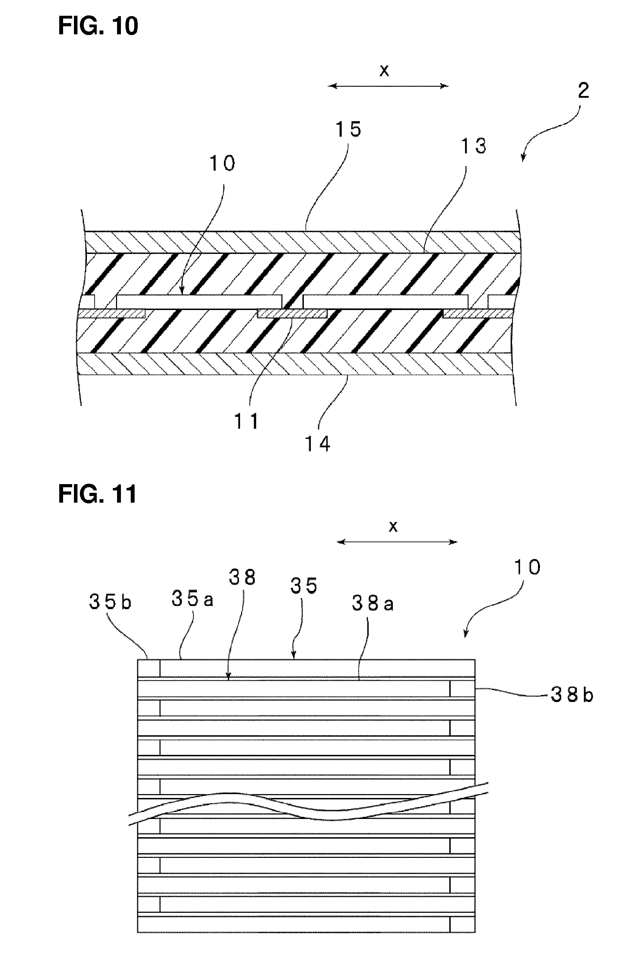

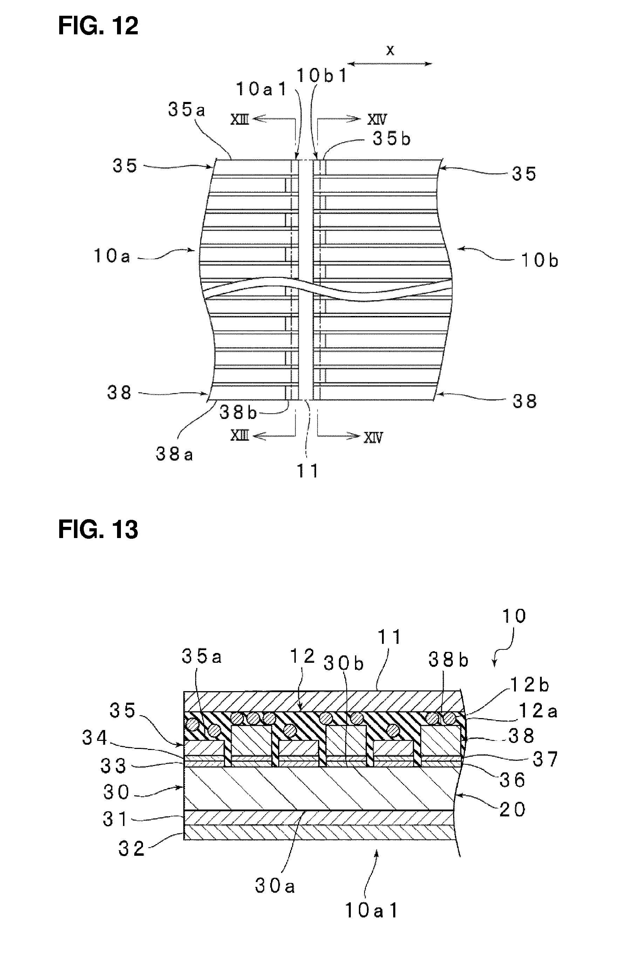

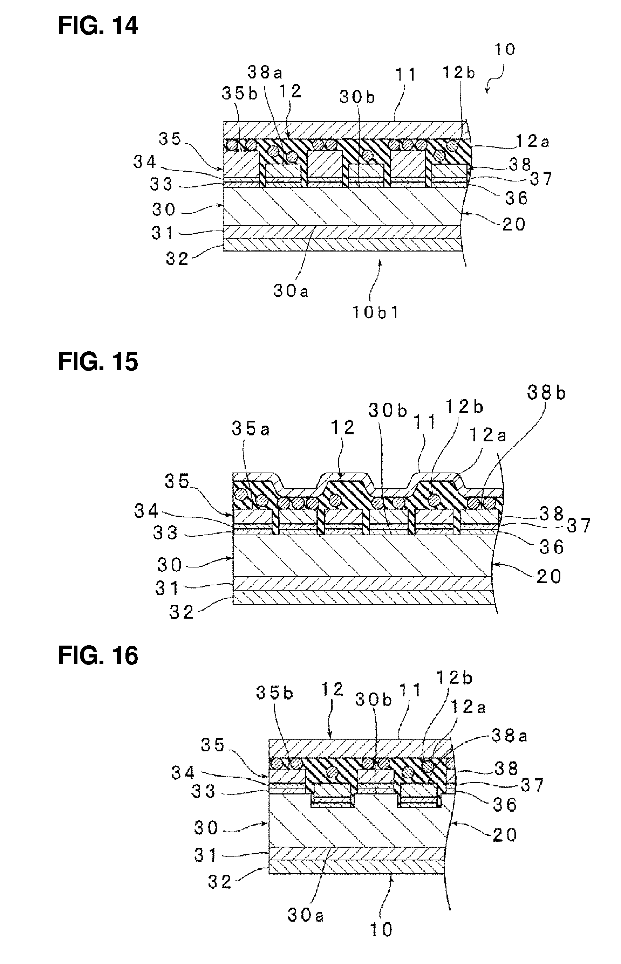

Fig. 10 is a schematic cross-sectional view of a solar cell module according to a second embodiment. Fig. 11 is a schematic plan view of a rear surface of the solar cell in the second embodiment. Fig. 12 is a schematic rear view for illustrating a connection structure between the solar cells in the second embodiment. Fig. 13 is a schematic cross-sectional view taken along line XIII-XIII in Fig. 12. Fig. 14 is a schematic cross-sectional view taken along line XIV-XIV in Fig. 12.

Solar cell module 2 according to the embodiment has the configuration same as that of solar cell module 1 according the first embodiment, except the configuration of solar cell 10 and a connection structure between solar cells 10 with wiring members 11. For this reason, the configuration of solar cell 10 and the connection structure between solar cells by wiring members 11 are described below, and the description of the first embodiment is incorporated herein for first and second protective members 14, 15, sealant 13 and anisotropic conductive adhesive layer 12 and the like.

### (Configuration of Solar Cell 10 in Second Embodiment)

In the above-described first embodiment, so-called through-hole type solar cell 10 is described as an example in which collecting electrodes 21 provided on light-receiving surface 20a are connected to electrodes 23 provided on rear surface 20b with connection electrodes 22 formed inside through-holes 20c. However, in the embodiment, the solar cell is not limited to a through-hole type solar cell. In the invention, the solar cell may be a solar cell other than a through-hole type solar cell, such as a back junction type solar cell. Hereinafter, a case where solar cell 10 is a back junction type solar cell is described as an example.

Specifically, solar cell 10 according to the embodiment is a back junction type solar cell with the BSF (Back Surface Field) structure and the HIT structure (registered trademark).

As shown in Figs. 13 and 14, in the embodiment, photoelectric conversion body 20 includes semiconductor substrate 30. Semiconductor substrate 30 has light-receiving surface 30a and rear surface 30b. Semiconductor substrate 30 creates carriers by receiving light on light-receiving surface 30a.

For example, semiconductor substrate 30 is formed of a crystalline semiconductor material or compound semiconductor material. A specific example of the compound semiconductor material includes, for example, GaAs or InP. A specific example of the crystalline semiconductor material includes, for example, crystalline silicon such as monocrystalline silicon having an n-type or p-type conductive type or polycrystalline silicon. Hereinafter, the embodiment describes a case where semiconductor substrate 30 is made of n-type crystal silicon.

I-type amorphous semiconductor layer 31 made of an intrinsic amorphous semiconductor (hereinafter, referred to as an "i-type semiconductor") is formed on light-receiving surface 30a of semiconductor substrate 30. An n-type amorphous semiconductor layer 32 having a conductive type same as semiconductor substrate 30 is formed on i-type amorphous semiconductor layer 31. A reflection suppression film (not shown) to suppress light reflection may be formed on n-type amorphous semiconductor layer 32.

On the other hand, multiple linear i-type amorphous semiconductor layers 33, 36 are alternately formed in parallel on the rear surface 30b side of semiconductor substrate 30. P-type amorphous semiconductor layer 34 is formed on each i-type amorphous semiconductor layer 33. P-side electrode (positive electrode) 35 is formed on each p-type amorphous semiconductor layer 34.

That is, in the embodiment, configured is the HIT structure in which i-type amorphous semiconductor layer 33 with a thickness substantially not contributing power generation is provided between an n-type crystalline semiconductor substrate 30 and p-type amorphous semiconductor layer 34. The HIT structure as described in the embodiment can suppress recombination of carriers in a junction interface and thus can improve photoelectric conversion property such as an output voltage.

Note that i-type amorphous semiconductor layer 33 can be formed of amorphous silicon into which dopant is not substantially doped. The p-type amorphous semiconductor layer 34 can be formed of amorphous silicon having a p-type conductivity into which p-type dopant is doped.

N-type amorphous semiconductor layer 37 is formed on each i-type amorphous semiconductor layer 36. An n-side electrode (negative electrode) 38 is formed on each n-type amorphous semiconductor layer 37.

That is, provided in the embodiment is the BSF structure in which i-type amorphous semiconductor layer 36 and n-type amorphous semiconductor layer 37 are provided between semiconductor substrate 30 and n-side electrode 38. This can effectively suppress recombination of minority carriers on rear surface 30b.

Note that i-type amorphous semiconductor layer 36 can be formed of amorphous silicon into which dopant is not substantially doped. The n-type amorphous semiconductor layer 37 can be formed of amorphous silicon having an n-type conductivity into which n-type dopant is doped.

P-side electrode 35 and n-side electrode 38 can be configured of a lamination body of, for example, a TCO (Transparent Conductive Oxide) layer and a metal layer or an alloy layer.

As shown in Fig. 11, p-side electrode 35 is formed of finger electrodes 35a on p-type amorphous semiconductor layer 34 and n-side electrode 38 is formed of finger electrodes 38a on n-type amorphous semiconductor layer 37, and do not have a bus bar. In other words, each of p-side electrode 35 and n-side electrode 38 is a so-called bus-bar-less collecting electrode. Finger electrodes 35a and finger electrodes 38a are alternately arranged in a direction perpendicular to a direction in which the finger electrodes 35a, 38a extend.

Note that the solar cell may be one without the BSF structure. In this case, for example, i-type amorphous semiconductor layer 36 and n-type amorphous semiconductor layer 37 are not provided, and n-side electrode 38 is provided on rear surface 30b of semiconductor substrate 30.

Also, the solar cell may be one without the HIT structure. In this case, for example, i-type amorphous semiconductor layer 33 is not provided, and p-type amorphous semiconductor layer 34 and p-side electrode 35 are provided on rear surface 30b of semiconductor substrate 30.

### (Connection structure between Solar Cells 10 in Second Embodiment)

Next, a connection structure between solar cells 10 in the embodiment is described by mainly referring to Figs. 11 to 14. Note that to simplify the description, a connection arrangement between adjacent solar cells 10a and 10b shown in Fig. 12 is described below as an example.

As shown in Figs. 11 and 12, one end portion of each finger electrode 35n in arrangement direction X is provided with protruded portion 35b thicker than the other portion of each finger electrode 35n, while the other end portion of each finger electrode 38a in arrangement direction X is provided with protruded portion 38b thicker than the other portion of each finger electrode 38a. As shown in Fig. 12, solar cell 10a and solar cell 10b are provided such that end portion 10a1 of solar cell 10a on a side where protruded portion 38b is provided is adjacent to end portion 10b1 of solar cell 10b on a side where protruded portion 35b is provided. End portion 10a1 of solar cell 10a where both p-side electrodes 35 and n-side electrodes 38 are provided is connected, with wiring members 11h, to end portion 10b1 of solar cell 10b where both p-side electrodes 35 and n-side electrodes 38 are provided. That is, in the embodiment, one side portion and the other side portion of wiring member 11 in the arrangement direction X are bonded to the portions on rear surface 10b of solar cell 10 where both p-side electrodes 35 and n-side electrodes 38 are provided.

Specifically, as shown in Figs. 13 and 14, in the embodiment, wiring member 11 is formed in a plate-shape. For this reason, a portion of anisotropic conductive adhesive layer 12, which is located between each protruded portion 35b and wiring member 11, is thinner than the other portion and a portion of anisotropic conductive adhesive layer 12, which is located between each protruded portion 38b and wiring member 11, is thinner than the other portions. Specifically, in the embodiment, a minimum thickness of the portions of anisotropic conductive adhesive layer 12, which is located between each of protruded portions 35b, 38b and wiring member 11 is equal to or smaller than maximum particle diameter of conductive particles 12b, and the minimum thickness of the other portions is larger than the maximum particle diameter of conductive particles 12b. With this configuration, protruded portions 35b and wiring member 11 are electrically connected to each other with conductive particles 12b and protruded portions 38b and wiring member 11 are electrically connected to each other with conductive particles 12b, while the portions other than the protruded portions 35b, 38b of finger electrodes 35a, 38a are electrically insulated from wiring member 11 by resin 12a.

In the embodiment, there is also no need to selectively form different kinds of layers such as a conductive layer and an insulation layer for connecting wiring member 11 to solar cell 10. In the embodiment, the anisotropic conductive adhesive is applied to the region where wiring member 11 faces solar cell 10, and then the anisotropic conductive adhesive is hardened in the state where wiring member 11 is pushed onto the solar cell 10 side, so that solar cell module 2 can be easily manufactured.

Furthermore, in the embodiment, protruded portions 35b of finger electrode 35a are located closer to the wiring member 11 than the other portion of finger electrode 38a other than protruded portion 38b. With this configuration, for example, in the end portion 10a1, by pushing plate-shaped wiring member 11 to the solar cell 10 side, wiring member 11 is electrically connected with protruded portions 38b of finger electrode 38s, while wiring member 11 is electrically insulated from finger electrodes 35a. Accordingly, the connection between solar cells 10 can be easily made. This configuration wherein the heights of finger electrodes 35a, 38a are different is particularly effective for a solar cell having narrow width electrodes like the embodiment.

Also, since anisotropic conductive adhesive layer 12 as an adhesive resin layer is also entirely formed on the portion where wiring member 11 faces rear surface 20b of solar cell 10 in the embodiment, the bonding strength between wiring member 11 and solar cell 10 is high. Accordingly, the durability of solar cell module 2 can be enhanced.

Furthermore, in the embodiment, resin 12a of anisotropic conductive adhesive layer 12 is formed between wiring member 11a and protruded portions 35b or 38b. With this, the bonding strength between wiring member 11 and finger electrodes 35a or 38a can be further enhanced. Accordingly, the reliability of the electrical connection between wiring member 11 and finger electrodes 35a or 38a can be further enhanced.

Also, in the embodiment, as described above, wiring member 11 can be bonded to the region where both finger electrodes 35a, 38a are provided, so that freedom of designing p-side electrode 35 and n-side electrode 38 is high. For example, as described in the embodiment, each of p-side electrode 35 and n-side electrode 38 can be a so-called bus-bar-less electrode, so that a photoelectric conversion rate can be further increased.

Note that, a reason why a photoelectric conversion rate tends to decrease when a bus bar is provided is as follows. When a bus bar is provided, a gap between the finger electrodes and the bus bar becomes larger than a gap between the finger electrodes. For this reason, minority carriers easily disappear due to recombination with majority carriers before reaching the finger electrodes or the bus bar. Accordingly, a photoelectric conversion rate tends to decrease when the bus bar is provided. Thus, the photoelectric conversion rate can be increased, by providing no bus bar and thus increasing the area of regions where the finger electrodes face the wiring member.

### (First to Fourth Modifications)

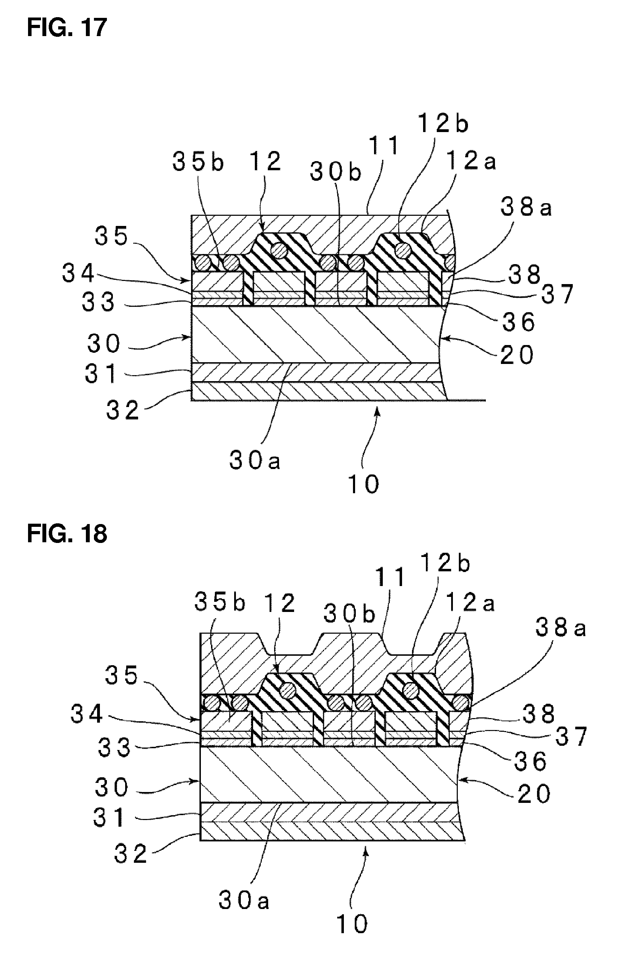

Fig. 15 is a schematic cross-sectional view for illustrating a connection structure between solar cells and a wiring member in a solar cell module according to a first modification. Fig. 16 is a schematic cross-sectional view for illustrating a connection structure between solar cells and a wiring member in a solar cell module according to a second modification. Fig. 17 is a schematic cross-sectional view for illustrating a connection structure between solar cells and a wiring member in a solar cell module according to a third modification. Fig. 18 is a schematic cross-sectional view for illustrating a connection structure between solar cells and a wiring member in a solar cell module according to a fourth modification.

In the above-described second embodiment, finger electrodes 35a and 38a are selectively electrically connected with wiring member 11 by adjusting the heights of finger electrodes 35a and 38a. However, the invention is not limited to this configuration. For example, as shown in Fig. 15, as similar to the first embodiment, finger electrodes 35a, 38a may be selectively electrically connected with wiring member 11 by having plate-shaped wiring member 11 curved while equalizing heights of finger electrodes 35a, 38a below wiring member 11. Also, finger electrodes 35a, 38a may be selectively electrically connected with wiring member 11 by having plate-shaped wiring member 11 curved while causing the heights of finger electrodes 35a and 38a to be different from each other below wiring member 11.

For example, as shown in Fig. 16, the surface of semiconductor substrate 30 may have protruded portions and recessed portions such that portions of anisotropic conductive adhesive layer 12 located between finger electrodes 35a and wiring member 11 have different thicknesses from portions of anisotropic conductive adhesive layer 12 located between finger electrodes 38a and wiring member 11. Specifically, in the example shown in Fig. 16, the recessed portions are provided at the portions of semiconductor substrate 30 where semiconductor substrate 30 faces finger electrodes 38a.

For example, as shown in Figs. 17 and 18, portions of anisotropic conductive adhesive layer 12 located between finger electrodes 35a and wiring member 11 may have different thicknesses from portions of anisotropic conductive adhesive layer 12 located between finger electrodes 38a and wiring member 11 by causing the portions of wiring member 11, which face one of finger electrodes 35a, 38a, to be thicker than the portions of wiring member which face the other of finger electrodes 35a, 38a. Specifically, in the example shown in Fig. 17, first surface of wiring member 11 which is close to the solar cell 10 side includes protruded portions, while second surface of the wiring member which is the other side thereof is formed flat. On the other hand, in the example shown in Fig. 18, both surfaces of wiring member 11 have protruded portions.

### (Fifth to Seventh Modifications)

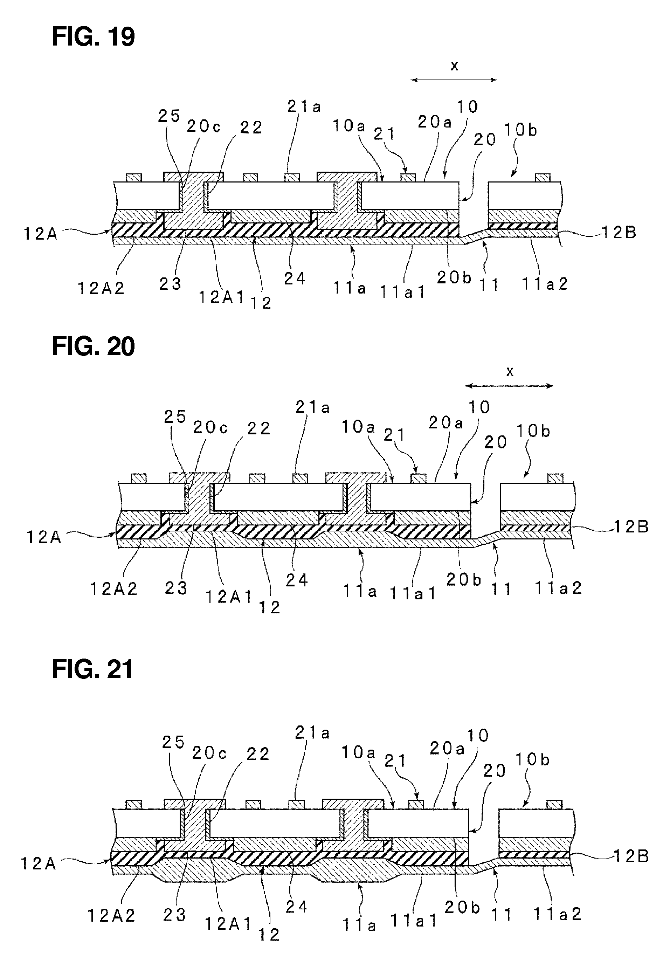

Fig. 19 is a schematic cross-sectional view for illustrating a connection structure between solar cells and a wiring member in a solar cell module according to a fifth modification. Fig. 20 is a schematic cross-sectional view for illustrating a connection structure between solar cells and a wiring member in a solar cell module according to a sixth modification. Fig. 21 is a schematic cross-sectional view for illustrating a connection structure between solar cells and a wiring member in a solar cell module according to a seventh modification.

In the above-described first embodiment, electrode 23, and collecting electrode 24 are selectively electrically connected with wiring member 11 by bending plate-shaped wiring member 11. However, the invention is not limited to this configuration.

For example, as shown in Fig. 19, finger electrodes 35a, 38a may be selectively electrically connected with wiring member 11 by forming one of electrode 23 and collecting electrode 24 to be thicker the other.

For example, electrode 23 and collecting electrode 24 may be selectively electrically connected with wiring member 11 by providing protruded portions and recessed portions on the surface of semiconductor substrate 30.

For example, as shown in Figs. 20 and 21, electrode 23 and collecting electrode 24 may be selectively electrically connected with wiring member 11 by causing a portion of wiring member 11, which faces one of electrode 23 and collecting electrode 24, to be thicker than a portion facing the other of electrode 23 and collecting electrode 24. Specifically, in the example shown in Fig. 20, a first surface of wiring member 11 which is on the solar cell 10 side is provided with protruded portions, and a second surface of wiring member 11 which is the other side thereof is formed flat. On the other hand, in the example shown in Fig. 21, both surfaces of wiring member 11 have protruded portions.

### (Eighth Modification)

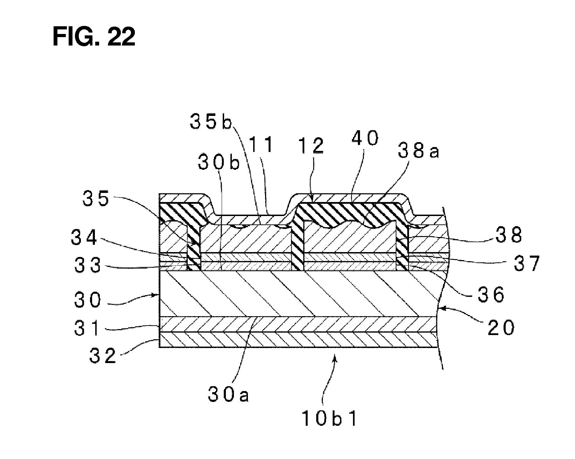

Fig. 22 is a schematic cross-sectional view for illustrating a connection structure between solar cells and a wiring member in a solar cell module according to an eighth modification of the second embodiment. Note that Fig. 22 depicts uneven portions on the surface of finger electrodes 35a, 38a larger than the actual ones as a matter of convenient explanation.

In the first and second embodiments and the first to seventh modifications, anisotropic conductive adhesive layer 12 is used as the adhesive resin layer. However, in the invention, the adhesive resin layer is not limited to the anisotropic conductive adhesive layer.

In the eighth modification, wiring member 11 is bonded to solar cell 10 by adhesive resin layer 40 made of only a resin having an insulation property. In this case, a distance between a wiring member and one of first and second electrodes having different polarities has to be shorter so that at least a part of the one of the first and second electrodes is in contact with the wiring member. At the same time, a distance between the wiring member and the other of the first and second electrodes has to be longer so that the other of the first and second electrodes is not in contact with the wiring member.

Specifically, in the modification, as shown in Fig. 22, uneven portions are formed on the surface of finger electrodes 35a, 38a. The method of forming the uneven portions is not particularly limited. For example, finger electrodes 35a, 38a are formed using the screen printing, so that uneven portions can be formed on the surface of finger electrodes 35a, 38a.

Then, in the embodiment, a part of finger electrode 35a is in contact with wiring member 11, while finger electrode 38a is insulated from wiring member 11 by adhesive resin layer 40, so that finger electrodes 35a, 38a are selectively electrically connected with wiring member 11. the protruded portions on the surface of finger electrode 35a is in contact with wiring member 11, while adhesive resin layer 40 is provided between wiring member 11 and the recessed portions on the surface of finger electrode 35a.

Even in this modification, effects similar to those of the embodiments and modifications using a conductive adhesive layer can be obtained.

### (Other Modifications)

In the above embodiments and modifications, the plate-shaped wiring member(s) made of a conductive metal or alloy is used. However, the invention is not limited to this configuration. In the invention, a wiring member may be a printed circuit board having a printed circuit thereon or inside thereof.

### DESCRIPTION OF REFERENCE NUMERALS

- 1, 2: solar cell module
- 10: solar cell
- 11: wiring member
- 12: anisotropic conductive adhesive layer
- 12a: resin
- 12b: conductive particle
- 20: photoelectric conversion body
- 20a, 30a: light-receiving surface
- 20b, 30b: rear surface
- 20c: through-hole
- 21, 24: collecting electrode
- 21a: finger electrode
- 22: connection electrode
- 23: electrode
- 30: semiconductor substrate
- 32: n-type amorphous semiconductor layer
- 34: p-type amorphous semiconductor layer
- 35: p-side electrode
- 35a, 38a: finger electrode
- 37: n-type amorphous semiconductor layer
- 38: n-side electrode
- 38a: finger electrode
- 40: adhesive resin layer

## Claims

1. A solar cell module comprising:
solar cells, each having first and second principal surfaces and first and second electrodes formed on the first principal surface, the first and second electrodes having polarities different from each other; and
a wiring member connecting the solar cells, in which at least one side portion of the wiring member is bonded to a portion of the first principal surface of the solar cell where both the first and second electrodes are provided, by an adhesive resin layer, wherein
a first portion of the adhesive resin layer, which is located between the one side portion of the wiring member and the first electrode, is thinner than a second portion of the adhesive resin layer, which is located between the one side portion of the wiring member and the second electrode such that the one side portion of the wiring member is electrically connected with the first electrode while the one side portion of the wiring member is electrically insulated from the second electrode.

2. The solar cell module according to claim 1, wherein the adhesive resin layer contains a resin and conductive particles dispersed in the resin, and a minimum thickness of the first portion of the adhesive resin layer is equal to or smaller than a maximum particle diameter of the conductive particles and a minimum thickness of the second portion of the adhesive resin layer is larger than the maximum particle diameter of the conducive particle.

3. The solar cell module according to claim 1 or 2, wherein the one side portion of the wring material is in contact with the first electrode.

4. The solar cell module according to claim 3, wherein the adhesive resin layer is provided between at least the one side portion of the wiring member and the first electrode.

5. The solar cell module according to claim 3 or 4, wherein
the first electrode has a protruded portion and a recessed portion on the surface, and
the protruded portion on the surface of the first electrode is in contact with the one side portion of the wiring member, and the adhesive resin layer is provided between the recessed portion of the surface of the first electrode and the one side portion of the wiring member.

6. The solar cell module according to any one of claims 1 to 5, wherein the adhesive resin layer is disposed entirely across a region where the one side portion of the wiring member faces the solar cell.

7. The solar cell module according to any one of claims 1 to 6, wherein
each solar cell includes:
a photoelectric conversion body including a light-receiving surface being the second principal surface, a rear surface being the first principal surface, and a through-hole formed therein and connecting the light-receiving surface and the rear surface, the photoelectric conversion body configured to generate carriers by receiving light on the light-receiving surface;
a light-receiving-surface electrode provided on the light-receiving surface of the photoelectric conversion body,
a connection electrode formed in the through-hole and electrically connected with the light-receiving-surface electrode;
the first electrode provided on the rear surface of the photoelectric conversion body and electrically connected with the light-receiving-surface electrode via the connection electrode; and
a rear-surface electrode serving as the second electrode and provided on the rear surface of the photoelectric conversion body.

8. The solar cell module according to any one of claims 1 to 6, wherein
each solar cell includes:
a semiconductor substrate made of one of a p-type semiconductor and an n-type semiconductor and including a light-receiving surface being the second principal surface and a rear surface being the first principal surface; and
a semiconductor layer made of the other of the p-type semiconductor and the n-type semiconductor and formed on a part of the rear surface of the semiconductor substrate, and
one of the first and second electrodes is formed on the rear surface of the semiconductor substrate and the other of the first and second electrodes is formed on the semiconductor layer.

9. The solar cell module according to claim 8, wherein
the first electrode includes line-shaped first finger electrodes parallel with each other, and
the second electrode includes second finger electrodes, parallel with the first finger electrodes and alternately provided with the first finger electrodes in a direction perpendicular to a direction along which the first finger electrodes extend.

10. The solar cell module according to any one of claims 1 to 9, wherein
the wiring member is formed in a plate shape, and
the first portion of the adhesive resin layer is thin such that a portion of the one side portion of the wiring member is curved protruding toward the first electrode, the portion being located above the first electrode.

11. The solar cell module according to any one of claims 1 to 9, wherein a portion of the one side portion of the wiring member is formed thicker than the other portions thereof, the portion being electrically connected with the first embodiment.

12. The solar cell module according to any one of claims 1 to 11, wherein an end portion of the first electrode on the wiring member side is located closer to the wiring member than an end portion of the second electrode on the wiring member side.

13. The solar cell module according to any one of claims 1 to 12, wherein an end portion of the at least one side portion of the wiring member is electrically connected with the first electrode.
